# EUROPÄISCHE PATENTSCHRIFT

(11) **EP 0 764 858 B1**
(45) Veröffentlichungstag und Bekanntmachung des Hinweises auf die Patenterteilung: **01.10.2003**
(21) Anmeldenummer: 96113892.2
(22) Anmeldetag: 30.08.1996
(51) Int. Cl.: G02B 5/30, G03F 7/20

(54) **Mikrolithographie-Projektionsbelichtungsanlage mit radial-polarisations-drehender optischer Anordnung**
Microlithographic projection illumination arrangement using device for producing radial polarisation
Appareil d'illumination microlithographique par projection utilisant un dispositif pour la production de la polarisation radiale

(30) Priorität: 23.09.1995 DE 19535392
(43) Veröffentlichungstag der Anmeldung: 26.03.1997
(60) Teilanmeldung: 03011501.8
(73) Patentinhaber: Carl Zeiss SMT AG, 73447 Oberkochen (DE)
(72) Erfinder: Schuster, Karl-Heinz, 89551 Königsbronn (DE)
(74) Vertreter: Gnatzig, Klaus

(56) Entgegenhaltungen:
- EP-A- 0 419 257
- DE-C- 3 523 641
- US-A- 4 286 843
- US-A- 5 365 371
- US-A- 5 436 761
- TIDWELL S C ET AL: "EFFICIENT RADIALLY POLARIZED LASER BEAM GENERATION WITH A DOUBLE INTERFEROMETER" APPLIED OPTICS, Bd. 32, Nr. 27, 20.September 1993, Seiten 5222-5229, XP000393432
- PATENT ABSTRACTS OF JAPAN vol. 013, no. 396 (E-815), 4.September 1989 -& JP 01 143216 A (NEC CORP), 5.Juni 1989,
- PATENT ABSTRACTS OF JAPAN vol. 096, no. 003, 29.März 1996 -& JP 07 307268 A (NEC CORP), 21.November 1995,

## Beschreibung

Die Erfindung betrifft eine optische Anordnung welche ein eintretendes Lichtbündel in ein austretendes Lichtbündel mit im gesamten Querschnitt im wesentlichen in radialer Richtung linear polarisiertem Licht umformt.

Zur Erzielung höchster Auflösungen in der Mikrolithographie ist es notwendig, Projektionsbelichtungsanlagen mit sehr hoher numerischer Apertur vorzusehen. Bei der Einkopplung des Lichts in die Resistschicht, die dann unter sehr hohen Winkeln erfolgt, kommt es zu Lichtverlusten durch Reflexion an der äußeren Resist-Grenzschicht und zu Verschlechterungen der Auflösung durch seitliches Auswandern des Lichts bedingt durch Reflexionen an den beiden Grenzschichten des Resists zum Wafer und zur Luft (Bildung von stehenden Wellen).

Der Fresnel'sche Reflexionsgrad ist dabei vom Winkel zwischen der Polarisationsrichtung und der Reflexionsebene abhängig. Für unter dem Brewster-Winkel einfallendes Licht mit parallel zur Einfallsebene schwingendem elektrischem Feld verschwindet die Reflexion, hierfür ergibt sich also optimale Einkopplung in den Resist, gleichzeitig maximale Unterdrückung der stehenden Wellen.

Bei insgesamt in einer Richtung linear polarisiertem Licht ergeben sich jedoch Störungen, wie in EP 0 602 923 A1 und EP 0 608 572 A2 beschrieben. Beide Schriften erzeugen daher vor der Einkopplung in den Resist gezielt zirkular polarisiertes Licht als Aequivalent zu unpolarisiertem Licht. Damit wird Homogenität über das ganze Bild erreicht, jedoch ein Wirkungsgradverlust hingenommen, da der jeweils lokal senkrecht polarisierte Lichtanteil stark reflektiert wird.

In EP 0 602 923 wird alternativ vorgeschlagen, das insgesamt in einer Richtung linear polarisierte Licht in Bezug auf die Orientierung eines abzubildenden Musters zu orientieren, wie auch schon aus DE-OS 15 72 195 bekannt. Die Unterwanderung durch Mehrfachreflexion erfolgt dann in Längsrichtung der Strukturen, nicht in Richtung der kritischen Auflösung. Der Wirkungsgrad der Einkopplung bzw. die Reflexion an der Resistoberfläche ist aber dabei nicht homogen.

Die Auswirkung der Polarisation auf die Reflexion an Resistschichten und die Bedeutung der Fresnel'schen Koeffizienten ist in US 4,899,055 für ein Verfahren zur Dickenmessung dünner Filme beschrieben.

Aus US 5,365,371 ist eine Projektionsbelichtungsanlage für die Mikrolithographie bekannt, bei der eine radial gerichtete Linearpolarisation des Lichts eingeführt wird, um Störungen bei der Bilderzeugung im Resist durch stehende Wellen im Resist zu unterbinden. Es werden zwei verschiedene polarisierende Elemente angegeben: Zunächst ein aus einem Positiv- und einem Negativkegel zusammengesetzter Radialpolarisationsfilter, der in Transmission benutzt wird und aufgrund der Fresnel'schen Gleichungen für die Reflexion radiale Polarisation bewirkt. Es ist nicht angegeben, wie eine vollständige Polarisation des transmittierten Lichts erzielt werden kann. In der Beschreibung und in Anspruch 3 wird zudem gefordert, daß beide Teile verschiedenen Brechungsindex aufweisen. Der transmittierte Teil muß aber dann gebrochen werden und kann nicht geradlinig passieren. In dem zugehörigen CIP-Patent US 5,436,761, das bis auf den Anspruch identisch ist, wird im Anspruch jedoch keine Bedingung für die Brechungsindices angegeben. Weiter wird z.B. in Anspruch 4 eine Platte mit Segmenten aus radial orientierten Polarisationsfilterfolien angegeben, wie sie auch schon aus US 4,286,843 (Fig. 19 und Beschreibung Spalte 9, Zeilen 60-68) bekannt ist.

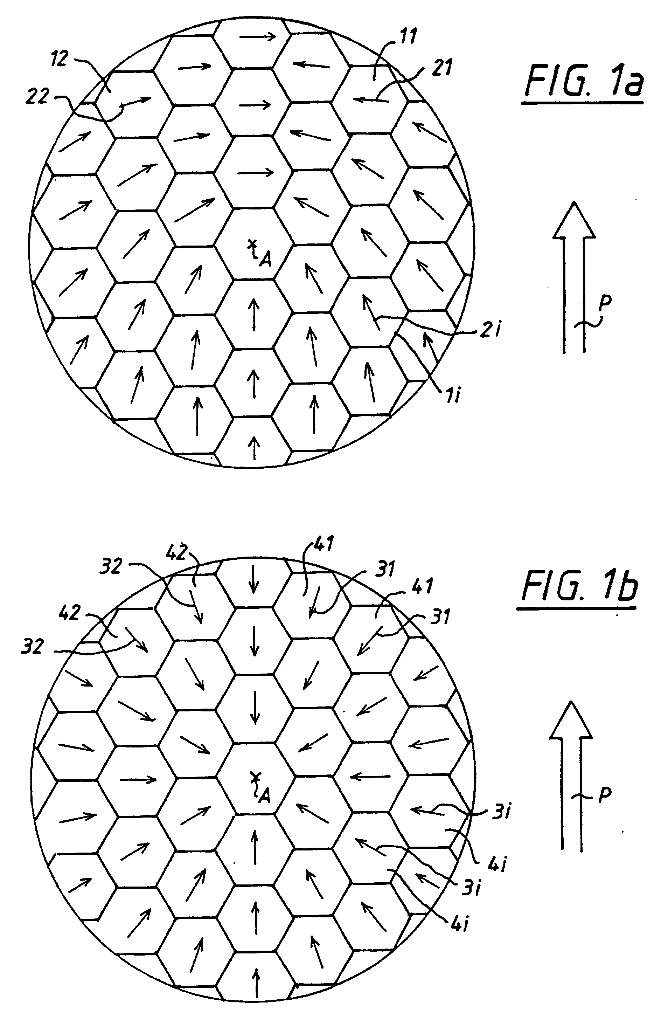

Beide Polarisatoren sind Polarisationsfilter, das heißt sie führen zu hohem Lichtverlust und sind nur für einen unpolarisierten oder zirkular polarisierten ankommenden Lichtstrahl geeignet, da sonst über den Querschnitt des austretenden Lichtbündels starke Inhomogenität der Intensität auftritt. Beim Beispiel der Fig. 1 bedingt der Umlenkspiegel (17) eine teilweise Polarisation, und deshalb ist das aus dem Polarisator (21) austretende Lichtbündel inhomogen. Auch wird in US 5,365,371 ausschließlich angegeben und beansprucht, daß der Radialpolarisator in der Pupillenebene des Projektionsobjektives liegt. Eine Lage des Radialpolarisators im Objektiv ist problematisch, da dort engste Toleranzen für eine optimale Bildqualität eingehalten werden müssen.

Aufgabe der Erfindung ist es, eine Mikrolithographie-Projektionsbelichtungsanlage anzugeben, die bei minimaler Störung der Abbildung bzw. minimalem Bauaufwand maximale Nutzung der Vorteile der radialen Linearpolarisation erlaubt.

Gelöst wird diese Aufgabe durch eine Mikrolithographie-Projektionsbelichtungsanlage nach Anspruch 1.

Vorteilhafte Ausführungsformen, die verschiedene Arten der Erzeugung der gewünschten Polarisationsverteilung angeben, sind Gegenstand der Unteransprüche 2 bis 13. Anspruch 10 ist besonders bevorzugt, da bei Ringaperturbeleuchtung der Lichteinfall unter geringen Winkeln, bei denen die Reflektivität nur geringe Polarisationsabhängigkeit zeigt, unterdrückt ist.

Bei diesen Anlagen, wo die Möglichkeiten der Optik voll ausgenützt werden, wird eine Verbesserung der Homogenität und des Wirkungsgrads der Lichteinkopplung in die Resistschicht erreicht, da die Reflexion am Resist, aber auch an allen nach dem polarisierenden Element angeordneten Linsen, gleichmäßig reduziert wird. Für das unter großen Winkeln (bis zum Brewster-Winkel) einfallende Licht ist der Effekt am stärksten, gerade da wo die Lichtintensität (Randabfall) am geringsten ist. Die Störungen der Auflösung durch Streulicht, auch an der Resist-Wafer-Grenzschicht, sind homogenisiert und verringert.

Eine Anordnung möglichst früh im Strahlengang ist vorteilhaft, da so die Störungen durch Spannungsdoppelbrechung an allen nachfolgenden Linsen minimiert und symmetrisiert werden.

Es ist daher auch für Polarisationsfilter, neben den bevorzugten polarisationsdrehenden Elementen, besonders vorteilhaft, wenn diese bereits im Beleuchtungssystem angeordnet werden.

Die bevorzugten Ausführungen nach den Ansprüchen 1 und 11 tragen dem Rechnung, daß mit der erfindungsgemäßen radialen Polarisationsrichtung an jeder Linse des Systems eine Reduzierung und Homogenisierung - wenn auch bei geringen Auftreffwinkeln in geringem Maße - des Streulichts eintritt, die genützt werden kann.

Andererseits ändern asymmetrische optische Elemente, insbesondere Umlenkspiegel wie sie zur Verkürzung der Baulänge oder in katadioptrischen Projektionsobjektiven vorgesehen werden, den Polarisationszustand und können daher nur dann nachgeschaltet sein, wenn eine reflektierende Schicht mit Phasenkorrektur benützt wird. Wird als umlenkendes Element ein totalreflektierendes Prisma eingesetzt, so muß eine genau angepaßte Phasenverzögerungsplatte nachgeschaltet werden, oder die totalreflektierende Grenzfläche muß mit einer phasenkorrigierenden Schicht belegt werden. Störend sind natürlich auch polarisierende optische Bauelemente, zum Beispiel Polarisationsstrahlteiler und Viertelwellenplatten.

Weitere vorteilhafte Ausführungsformen beschreiben die Ansprüche 5, 12 und 13.

Näher erläutert wird die Erfindung anhand der Zeichnung, deren schematische Figuren das folgende zeigen:
- Fig. 1a: eine Aufsicht auf eine radial polarisationsdrehende optische Anordnung aus einem Raster von Halbwellenplatten, für linear polarisiertes einfallendes Licht;
- Fig. 1b: die Polarisationsrichtungen des aus Fig. 1a austretenden Lichtbündels;
- Fig. 2: im Querschnitt eine radial polarisierende optische Anordnung mit Kegelstumpfreflektor mit Brewsterwinkel, für zirkular polarisiertes oder unpolarisiertes einfallendes Licht (Stand der Technik);
- Fig. 3a: eine Anordnung mit Kegelstumpfreflektor und segmentartigen Halbwellenplatten zur vollen Nutzung von zirkularpolarisiertem oder unpolarisiertem Licht, im Querschnitt;
- Fig. 3b: dasselbe in Ansicht von der Lichtaustrittsseite her;
- Fig. 4a: eine radial polarisationsdrehende optische Anordnung mit einer Platte mit zentralsymmetrischer Spannungsdoppelbrechung in Seitenansicht,
- Fig. 4b: die zugehörige Viertelwellenplatte in Ansicht,
- Fig. 4c: die zugehörige Druckspannungsplatte in Ansicht,
- Fig. 4d: die zugehörige zirkular doppelbrechende 45°-Platte in Ansicht;
- Fig. 5: eine Mikrolithographie-Projektionsbelichtungsanlage mit radial polarisierender optischer Anordnung im Beleuchtungsteil;
- Fig. 6: ein katadioptrisches Projektionsobjektiv mit darin integrierter erfindungsgemäßer radial polarisierender optischer Anordnung;

Eine erfindungsgemäße polarisationsdrehende Anordnung, wie sie besonders in Verbindung mit einem Wabenkondensor vorteilhaft ist, geeignet für die Umwandlung von linear polarisiertem Licht, also besonders für Laser als Lichtquelle, ist in Fig. 1a in Aufsicht dargestellt. Der Lichtbündelquerschnitt ist in eine Vielzahl von Facetten (11, 12,1i) aufgeteilt, die jeweils aus einer Halbwellenplatte aus doppelbrechendem Material bestehen. Jede Facette (1i) entspricht einem Wabenelement des Wabenkondensors. Die Facetten (1i) sind zweckmäßigerweise auf die Wabenelemente aufgekittet, angesprengt, oder bei extremer Strahlenbelastung separat gefaßt und entspiegelt. Die bei Mikrolithographie-Projektionsbelichtungsanlagen üblichen Wabenkondensoren haben um 10² Wabenelemente, und die Zahl der Facetten ist gleich.

Die Hauptachsen (21, 22, 2i) der Facetten (11, 1i) sind jeweils in Richtung der Winkelhalbierenden zwischen der Polarisationsrichtung des eintretenden insgesamt gleich linear polarisierten Lichts und dem jeweiligen zur optischen Achse (A) des Lichtbündels und des Wabenkondensors gerichteten Radius durch die Mitte jeder Facette (1i) ausgerichtet. Damit bewirkt jede Halbwellenplatten-Facette (1i) die Drehung der Polarisationsrichtung in die Richtung des genannten Radius. Fig. 1b zeigt diesen Effekt, hier sind die Eintrittsflächen (41, 42, 4i) des Wabenkondensors gezeigt mit den Polarisationsrichtungen (31, 32, 3i) der jeweiligen Teillichtbündel, die alle radial ausgerichtet sind.

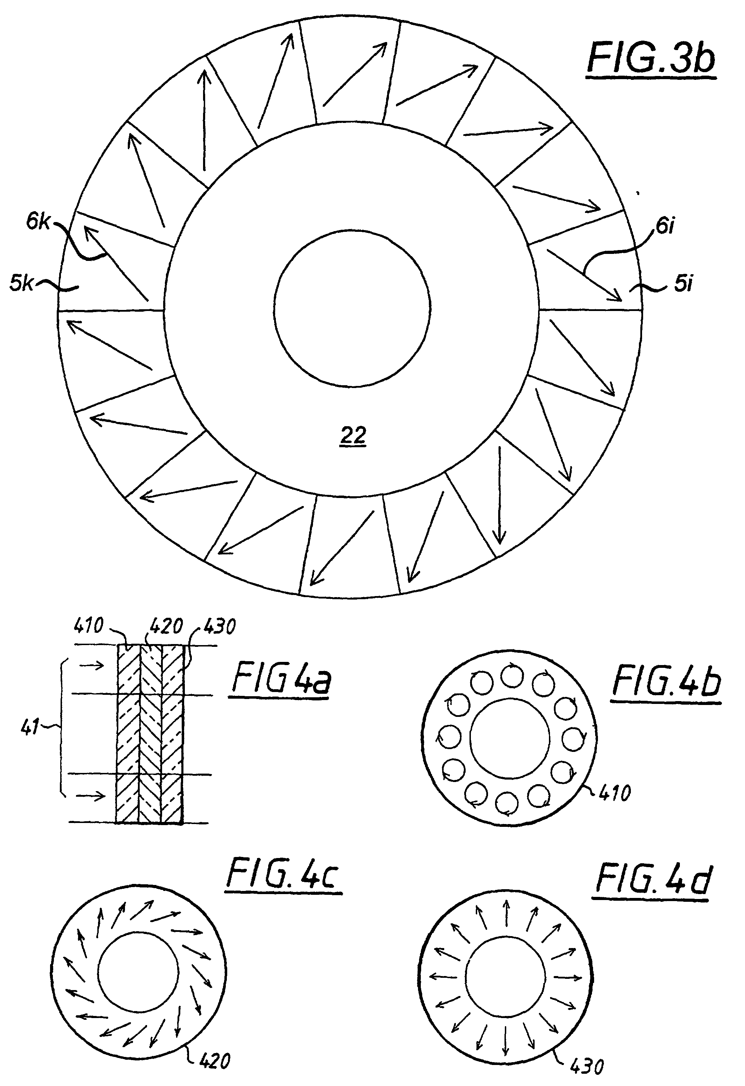

Die Rasterung mit hexagonalen Facetten (1i) ist dabei nur ein Ausführungsbeispiel, das besonders für die Kombination mit einem Wabenkondensor angepaßt ist. Andere Rasterungen, insbesondere auch fächerartige Sektoreneinteilungen der Halbwellenplatten (vgl. Fig. 3b) sind sinnvoll möglich. Die Zahl der Einzelelemente kann auch im Bereich 10¹ liegen.

Eine Verminderung des gesamten Reflexionsgrads an einer optischen Grenzfläche gegenüber unpolarisiertem Licht ergibt sich solange, wie überall im Bündelquerschnitt der Anteil des senkrecht zur Einfallsebene polarisierten Lichts kleiner als der Anteil des parallel polarisierten Lichts ist. Bei nur vier 90°-Sektoren mit Halbwellenplatten wird dieser Grenzfall erreicht, so daß bevorzugt mehr Halbwellenplatten im Lichtbündelquerschnitt angeordnet werden, insbesondere größenordnungsmäßig 10 bis 10² Facetten oder Sektoren.

Im Unterschied zu bekannten Radialpolarisatoren mit Sektoren (US 5,365,371 und US 4,286,843) wird nicht mit erheblichem Verlust die Polarisation ausgefiltert, sondern das Licht wird in seiner Polarisationsrichtung durch doppelbrechende Elemente verändert bei minimalen Verlusten.

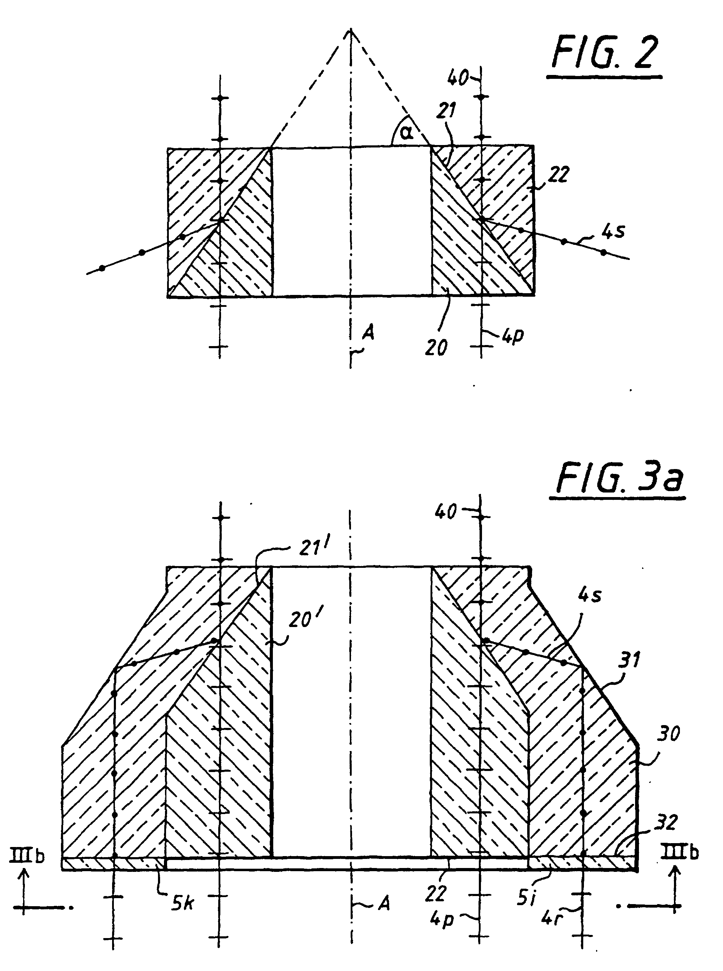

Eine stetige radiale Ausrichtung der linearen Polarisation bewirkt die in Fig. 2 dargestellten optische Anordnung für eintretendes unpolarisiertes oder zirkular polarisiertes Licht (40). Sie ist ein Polarisationsfilter und im Prinzip aus US 5,365,371 bekannt, im Detail jedoch neu.

Es handelt sich um einen hohlgebohrten Kegelstumpf (20) aus transparentem Material, z.B. Glas FK5, Quarzglas oder CaF₂, mit dem Kegelwinkel α entsprechend dem Brewsterwinkel und einer dielektrischen Reflexbeschichtung auf dem Kegelmantel (21). Der senkrecht zur Einfallsebene polarisierte Teil (47) des Lichtstrahls (40) wird daher voll reflektiert, der transmittierte Strahl (4p) ist voll parallel zur Einfallsebene polarisiert, und damit überall radial zur optischen Achse (A) hin linear polarisiert. Der hohlgebohrte Kegelstumpf (20) ist für eine Ringaperturbeleuchtung adaptiert und sorgt für kürzeste Baulänge, natürlich funktioniert auch ein Vollkegel. Der Kegelstumpf (20) ist durch einen passenden Hohlkegelstumpf (22), der an der Kegelfläche (21) anliegt, zu einem Zylinderring ergänzt, wodurch die spiegelnde Kegelfläche (21) geschützt ist und das ganze leichter zu fassen ist. Kegelstumpf (20) und Hohlkegel (22) haben den gleichen Brechungsindex, so daß der Lichtdurchtritt ohne Brechung an der Kegelfläche (21) erfolgt, im Gegensatz zur US 5,365,371.

Fig. 3a zeigt im Querschnitt eine Weiterentwicklung der Ausführung nach Fig. 2, bei der auch der reflektierte Teil (4s) genutzt wird, so daß also eine Anordnung mit weitaus weniger als 50% Lichtverlust erreicht wird, da die Polarisation effektiv gedreht und nicht gefiltert wird.

Um den Kegelstumpf (20') mit dem Kegelmantel (21') entsprechend Fig. 2 (mit anschließendem zylindrischem Verlängerungsteil) ist ein transparentes Teil (30) mit einer zum Kegelmantel (21') parallelen spiegelnden Kegelfläche (31) angeordnet, an dessen Austrittsfläche (32) ein Ring aus Segmenten (5i, 5k) von Halbwellenplatten angeordnet ist, deren Hauptachsen (6i, 6k) jeweils unter 45° zum Radius in Segmentmitte stehen, wie in Fig. 3b gezeigt. Damit wird, wie bei Fig. 1 beschrieben, die radiale Linearpolarisation auch des am Kegelmantel (21') reflektierten Lichts (4s) im achsparallelen Bündel (4r) bewirkt. Die bewirkte Erhöhung des Lichtleitwertes ist zumindest bei Laserlichtquellen vielfach erwünscht. Wichtig ist, daß die Anordnung für unpolarisiert einfallendes Licht geeignet ist.Durch Weglassen oder Hinzufügen von optischem Glas kann im Bedarfsfall der optische Weg von Kegelstumpf (20') und transparentem Teil (30) angepaßt werden.

Eine ebenfalls stetig radial linear polarisiertes Licht erzeugende Anordnung, hier aber für linear oder zirkular polarisiertes Licht am Eingang und mit geringer Baulänge in Richtung der optischen Achse, zeigt das Beispiel gemäß den Figuren 4a bis 4d. Es ist besonders für Ringapertur-Optiken geeignet.

Ein Ring-Bündel von einheitlich linear polarisiertem Licht (41) trifft wie in Fig. 4a im Schnitt dargestellt auf einen Stapel von drei Planplatten (410, 420, 430). (410) ist eine Viertelwellenplatte, die wie Fig. 4b zeigt, das durchtretende Licht zirkular polarisiert. Ist das eintretende Lichtbündel bereits zirkular polarisiert, so kann die Platte (410) entfallen. Darauf folgt eine Platte (420), z.B. aus Glas oder Quarzglas, die unter zentralsymmetrischer Druckspannung steht und daher Spannungsdoppelbrechung zeigt. Dicke, Material und Spannung sind so ausgewählt, daß die Platte (420) im vom Ring-Bündel (41) berührten Außenbereich lokal jeweils eine Viertelwellenplatte ist, aber mit radialer Symmetrie, so daß das zirkular polarisiert eintretende Licht linear polarisiert wird, und zwar überall im Querschnitt mit der Polarisationsrichtung unter 45° zum Radius, vgl. Fig. 4c.

Im Zusammenwirken von Wärmeausdehnung und Temperaturgradienten beim Abkühlen oder bei einer Ausgleichs-Wärmebehandlung entsteht bei kreisrunden Glas-(oder Quarzglas, Berylliumfluorid, CaF₂ usw.)Scheiben immer eine derartige Druckspannung, die normalerweise durch möglichst langsames Abkühlen minimiert wird. Durch gezieltes Kühlen läßt sich aber in weiten Grenzen die gewünschte Druckspannung und damit die gewünschte Spannungsdoppelbrechung im Außenbereich erzeugen.

Darauf folgt noch eine dritte Platte (430), die zirkulare Doppelbrechung aufweist und die Polarisationsrichtung um 45° dreht. Damit wird, wie Fig. 4d zeigt, die radiale Polarisation des austretenden Lichts über den gesamten Querschnitt erreicht.

Diese Ausführung hat wie das Beispiel der Fig. 1 den Vorteil, besonders dünn zu sein, und wie das Beispiel der Fig. 2 den Vorteil, exakt radiale Polarisation zu ergeben ohne aufwendige Montage vieler Facetten oder Segmente. Hauptvorteil ist auch der hohe Wirkungsgrad, da die Polarisation gedreht, nicht selektiert wird. Wird statt des Ringbündels (41) ein vollständiges Bündel durch die Anordnung geschickt, so wird der Kernbereich einfach nicht beeinflußt.

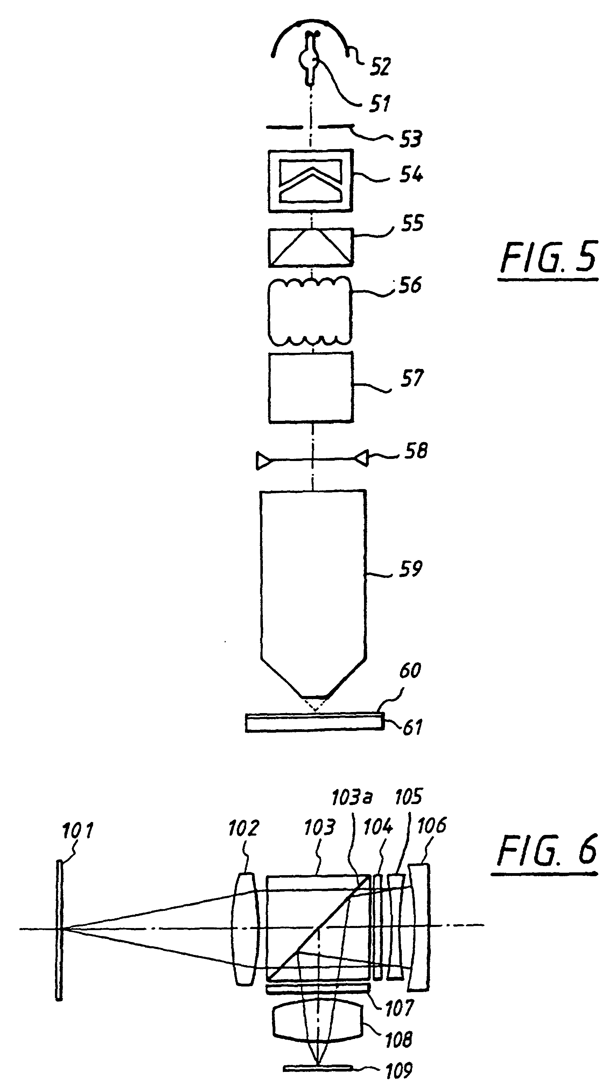

Fig. 5 zeigt schematisch eine komplette Mikrolithographie-Projektionsbelichtungsanlage mit einer radial polarisierenden optischen Anordnung (55), hier ein Kegelstumpfpolarisator nach Fig. 2. Außer diesem Element und seiner Anordnung sind alle Teile und ihre Anordnung branchenüblich. Eine Lichtquelle (51), z.B. eine i-Linie-Quecksilberentladungslampe mit Spiegel (52), beleuchtet eine Blende (53). Ein Objektiv (54), z.B. ein Zoom-Axicon-Objektiv nach DE 44 21 953, folgt und ermöglicht verschiedene Einstellungen, insbesondere die Wahl einer Ringapertur.

Auf den Kegelstumpfpolarisator (55), der für unpolarisiertes eintretendes Licht geeignet ist, folgt ein Wabenkondensor (56) und eine Relais- und Feldoptik (57). Diese Teile zusammen dienen der optimierten Beleuchtung des Reticle (58) - der Maske -, das durch das Projektionsobjektiv (59) verkleinert mit höchster Auflösung (unter 1 µm) auf den Resist-Film (60) des Wafers (61) abgebildet wird. Die numerische Apertur des Systems liegt bei Werten oberhalb 0,5 bis 0,9, wobei Ringaperturen zwischen 0,7 und 0,9 bevorzugt sind. Die radiale Polarisation des Lichts nach Verlassen des Kegelstumpfpolarisators (55) bewirkt, daß an allen folgenden optischen Elementen (56, 57, 58, 59) die Wirkung der Spannungsdoppelbrechung rotationssymmetrisch bezüglich der optischen Achse ist. Am größten ist der Effekt beim Eintritt in den Resistfilm (60), wo die größten Eintrittswinkel auftreten und daher optimale Transmission und minimale Reflexion erreicht werden. Der empfindliche Strahlengang im Projektionsobjektiv (59) ist ungestört.

Natürlich ist die Ausführung der polarisierenden optischen Anordnung (55) nicht auf das gezeigte Ausführungsbeispiel der Fig. 2 beschränkt, besonders alle erfindungsgemäßen polarisationsdrehenden Anordnungen stehen zur Wahl, eventuell mit vorgeschaltetem Polarisator oder doppelbrechender Platte zur Anpassung. Auch kann eine polarisationsdrehende optische Anordnung (55) an einen anderen Ort im Gesamtaufbau verlegt werden.

Das gilt besonders dann, wenn Umlenkspiegel ohne Phasenkorrektur oder polarisierende Elemente, z. B. Polarisationsstrahlteiler, vorgesehen sind. Dann ist die erfindungsgemäße polarisationsdrehende optische Anordnung dahinter (in Lichtflußrichtung) anzuordnen. Ein Beispiel dafür zeigt Fig. 6 anhand eines katadioptrischen Projektionsobjektivs.

Die Fig. 6 entspricht völlig der Fig. 1 der EP 0 602 923 A1 mit polarisierendem Strahlteiler (103), Konkavspiegel (106), Linsengruppen (102, 105, 108) und Viertelwellenplatte (104). Das polarisationsdrehende optische Element (107) ist hier aber nicht, wie bereits in der Einleitung beschrieben, wie bei EP 0 602 923 A1 eine Viertelwellenplatte zur zirkularen Polarisierung und damit gleichmäßigen Verschlechterung der Lichteinkopplung in das Resist (109), und auch nicht ein Mittel zur Ausrichtung der gleichmäßigen Linearpolarisation auf eine Vorzugsrichtung des Musters auf dem Reticle (101). Vielmehr ist hier eine radial polarisationsdrehende optische Anordnung (107) vorgesehen.

Wegen des geringen zur Verfügung stehenden Raums eignen sich hier die Ausführungen nach Fig. 1 und 4 am besten. Der Vorteil ist klar: unabhängig vom Muster des Einzelfalls wird optimale Streulichtunterdrückung und gleichmäßiger Wirkungsgrad der Lichteinkopplung in das Resist (109) erreicht.

Die radial polarisierende optische Anordnung (107) ist sobald wie möglich hinter dem Umlenkspiegel (103a) angeordnet im nahezu kollimierten Strahlengang, also in einem Bereich mäßiger Winkel und Divergenzen der Lichtstrahlen. Kleine Winkel sind wichtig für ein einwandfreies Funktionieren der doppelbrechenden Elemente. Beste Wirkung wird erzielt, wenn die Austrittsebene der erfindungsgemäßen polarisationsdrehenden Elemente in einer zur Bildebene fouriertransformierten Ebene des Beleuchtungs- oder Projektionssystems liegen, oder in einer dazu aequivalenten Ebene.

## Patentansprüche

1. Mikrolithographie-Projektionsbelichtungsanlage umfassend
• eine Lichtquelle (51),
• ein Beleuchtungssystem (52, 53, 54, 56, 57) zum Beleuchten einer Maske (58),
• ein Projektionsobjektiv (59) zur Abbildung der Maske (58) auf einen Wafer (61),
• eine optische Anordnung (55) zum Umformen eines eintretenden Lichtbündels in ein Lichtbündel mit im gesamten Querschnitt im wesentlichen in radialer Richtung linear polarisiertem Licht,
**dadurch gekennzeichnet,**
**daß** die optische Anordnung (55) zwischen Lichtquelle (51) und Maske (58) angeordnet ist.

2. Mikrolithographie-Projektionsbelichtungsanlage nach Anspruch 1 wobei die optische Anordnung (55) mindestens ein doppelbrechendes Element (11, 12, 1i, 5i, 5k, 430) umfaßt, um die Polarisationsrichtungen des eintretenden Lichtbündels im wesentlichen intensitätsverlustfrei zu drehen.

3. Mikrolithographie-Projektionsbelichtungsanlage nach Anspruch 1 oder 2, wobei die optische Anordnung mindestens vier Halbwellenplatten, (41, 42; 4i) mit jeweils unterschiedlich ausgerichteten Hauptachsen (21, 22; 2i) umfaßt.

4. Mikrolithographie-Projektionsbelichtungsanlage nach Anspruch 3, wobei die Halbwellenplatten in einer Ebene angeordnet sind.

5. Mikrolithographie-Projektionsbelichtungsanlage nach Anspruch 3 oder 4, wobei im Beleuchtungssystem ein Wabenkondensor (56) vorgesehen ist und jeder Wabe des Wabenkondensors (56) eine Halbwellenplatte (41,42,4i) zugeordnet ist.

6. Mikrolithographie-Projektionsbelichtungsanlage nach Anspruch 3 oder 4, wobei die optische Anordnung einen Reflexionspolarisator (20') mit einer kegelmantel- oder kegelstumpfmantel-förmigen polarisierenden Fläche (21') umfaßt und in dem Strahlengang des am Reflexionspolarisator (20') reflektierten Lichts die Halbwellenplatten (5k, 5i) angeordnet sind.

7. Mikrolithographie-Projektionsbelichtungsanlage nach Anspruch 1, wobei die optische Anordnung eine unter zentralsymmetrischer Druckspannung stehende spannungsdoppelbrechende Platte (420) umfaßt.

8. Mikrolithographie-Projektionsbelichtungsanlage nach Anspruch 7, wobei der spannungsdoppelbrechenden Platte (420) eine zirkular doppelbrechende um 45° drehende Platte (430) nachgeordnet ist.

9. Mikrolithographie-Projektionsbelichtungsanlage nach Anspruch 7 oder 8, wobei der optischen Anordnung eine Viertelwellenplatte (410) vorgeschaltet ist.

10. Mikrolithographie-Projektionsbelichtungsanlage nach einem der Ansprüche 1 bis 9, wobei das Beleuchtungssystem Ringaperturbeleuchtung erzeugt.

11. Mikrolithographie-Projektionsbelichtungsanlage nach einem der Ansprüche 1 bis 10, wobei das Beleuchtungssystem mindestens ein nicht zur optischen Achse symmetrisches polarisierendes Bauteil umfaßt und die optische Anordnung (55) in Lichtflußrichtung hinter dem dem Wafer am nächsten liegenden nicht zur optischen Achse symmetrischen polarisierenden Bauteil angeordnet ist.

12. Mikrolithographie-Projektionsbelichtungsanlage nach einem der Ansprüche 1 bis 11, wobei die optische Anordnung in einem Bereich mit kollimiertem Strahlengang angeordnet ist.

13. Mikrolithographie-Projektionsbelichtungsanlage nach einem der Ansprüche 1 bis 12, wobei die optische Anordnung in einer zur Maskenebene (58) fouriertransformierten Ebene oder in einer dazu äquivalenten Ebene angeordnet ist.

## Claims

1. Microlithography projection exposure installation comprising
• a light source (51),
• an illumination system (52, 53, 54, 56, 57) for illuminating a mask (58),
• a projection objective (59) for imaging the mask (58) onto a wafer (61),
• an optical arrangement (55) for converting an entering light pencil into a light pencil with light that is linearly polarized in the entire cross section essentially in the radial direction,
**characterized**
**in that** the optical arrangement (55) is arranged between light source (51) and mask (58).

2. Microlithography projection exposure installation according to Claim 1,
the optical arrangement (55) comprising at least one birefringent element (11, 12, 1i, 5i, 5k, 430) in order to rotate the directions of polarization of the entering light pencil essentially in a manner free of intensity loss.

3. Microlithography projection exposure installation according to Claim 1 or 2, the optical arrangement comprising at least four half-wave plates (41, 42; 4i) having in each case differently oriented principal axes (21, 22; 2i).

4. Microlithography projection exposure installation according to Claim 3, the half-wave plates being arranged in one plane.

5. Microlithography projection exposure installation according to Claim 3 or 4, a honeycomb condenser (56) being provided in the illumination system and each honeycomb of the honeycomb condenser (56) being assigned a half-wave plate (41, 42; 4i).

6. Microlithography projection exposure installation according to Claim 3 or 4, the optical arrangement comprising a reflection polarizer (20') with a polarizing face (21') in the shape of a cone envelope or truncated cone envelope and the half-wave plates (5k, 5i) being arranged in the beam path of the light reflected at the reflection polarizer (20').

7. Microlithography projection exposure installation according to Claim 1, the optical arrangement comprising a stress-birefringent plate (420) under centrosymmetrical compressive stress.

8. Microlithography projection exposure installation according to Claim 7, a circularly birefringent plate (430) rotating through 45° being arranged downstream of the stress-birefringent plate (420).

9. Microlithography projection exposure installation according to Claim 7 or 8, a quarter-wave plate (410) being arranged upstream of the optical arrangement.

10. Microlithography projection exposure installation according to one of Claims 1 to 9, the illumination system generating ring aperture illumination.

11. Microlithography projection exposure installation according to one of Claims 1 to 10, the illumination system comprising at least one polarizing component that is not symmetrical with respect to the optical axis, and the optical arrangement (55) being arranged, in the light flux direction, behind the polarizing component that is not symmetrical with respect to the optical axis and lies nearest to the wafer.

12. Microlithography projection exposure installation according to one of Claims 1 to 11, the optical arrangement being arranged in a region with a collimated beam path.

13. Microlithography projection exposure installation according to one of Claims 1 to 12, the optical arrangement being arranged in a plane that is Fourier-transformed with respect to the mask plane (58) or in a plane equivalent thereto.

## Revendications

1. Appareil d'illumination microlithographique par projection comprenant
* une source de lumière (51),
* un système d'éclairage (52, 53, 54, 56, 57) pour éclairer un masque (58),
* un objectif de projection (59) pour représenter le masque (58) sur une galette (61),
* un arrangement optique (55) pour déformer un faisceau lumineux incident dans un faisceau lumineux dont la lumière est essentiellement polarisée de manière linéaire dans le sens radial dans toute sa section,
**caractérisé en ce**
**que** l'arrangement optique (55) est disposé entre la source de lumière (51) et le masque (58).

2. Appareil d'illumination microlithographique par projection selon la revendication 1, avec lequel l'arrangement optique (55) comprend au moins un élément biréfringent (11, 12, 1i, 5i, 5k, 430) afin de faire tourner les sens de polarisation du faisceau lumineux incident pratiquement sans pertes d'intensité.

3. Appareil d'illumination microlithographique par projection selon la revendication 1 ou 2, avec lequel l'arrangement optique comprend au moins quatre plaques demi-onde (41, 42 ; 4i) ayant chacune des axes principaux (21, 22 ; 2i) dirigés dans des directions différentes.

4. Appareil d'illumination microlithographique par projection selon la revendication 3, avec lequel les plaques demi-onde sont disposées dans un plan.

5. Appareil d'illumination microlithographique par projection selon la revendication 3 ou 4, avec lequel un condenseur de rayons (56) est prévu dans le système d'éclairage et une plaque demi-onde (41, 42, 4i) est associée à chaque rayon du condenseur de rayons (56).

6. Appareil d'illumination microlithographique par projection selon la revendication 3 ou 4, avec lequel l'arrangement optique comprend un polariseur à réflexion (20') muni d'une surface polarisante (21') en forme d'aire latérale de cône ou d'aire tronconique et les plaques demi-onde (5k, 5i) dont disposées dans le trajet des rayons de la lumière réfléchie sur le polariseur à réflexion (20').

7. Appareil d'illumination microlithographique par projection selon la revendication 1, avec lequel l'arrangement optique comprend une plaque de biréfringence par compression (420) qui se trouve sous une contrainte de tension symétrique centrale.

8. Appareil d'illumination microlithographique par projection selon la revendication 7, avec lequel la plaque de biréfringence par compression (420) est suivie d'une plaque de biréfringence circulaire (430) pouvant tourner sur 45°.

9. Appareil d'illumination microlithographique par projection selon la revendication 7 ou 8, avec lequel une plaque quart d'onde (410) vient après l'arrangement optique.

10. Appareil d'illumination microlithographique par projection selon l'une des revendications 1 à 9, avec lequel le système d'éclairage génère un éclairage à ouverture annulaire.

11. Appareil d'illumination microlithographique par projection selon l'une des revendications 1 à 10, avec lequel le système d'éclairage comprend au moins un composant polarisant non symétrique par rapport à l'axe optique et l'arrangement optique (55) est disposé derrière le composant polarisant non symétrique par rapport à l'axe optique qui est le plus proche de la galette dans le sens de flux de la lumière.

12. Appareil d'illumination microlithographique par projection selon l'une des revendications 1 à 11, avec lequel l'arrangement optique est disposé dans une zone où le trajet du rayon est collimaté.

13. Appareil d'illumination microlithographique par projection selon l'une des revendications 1 à 12, avec lequel l'arrangement optique est disposé dans un plan obtenu par transformée de Fourier du plan du masque (58) ou dans un plan équivalent.
